**Europäisches Patentamt**

**European Patent Office**

**Office européen des brevets**

(19)

(11) Veröffentlichungsnummer: **0 008 106**
**B1**

# EUROPÄISCHE PATENTSCHRIFT

(12)

(45) Veröffentlichungstag der Patentschrift:
**15.07.81**

(51) Int. Cl.³: **H 01 L 27/02,** H 01 L 21/76

(21) Anmeldenummer: **79102831.9**

(22) Anmeldetag: **06.08.79**

(54) **Halbleitervorrichtung mit mehreren in einem Halbleiterkristall vereinigten und eine integrierte Schaltung bildenden Halbleiterelementen mit pn-Übergängen.**

(30) Priorität: **08.08.78 DE 2834719**

(43) Veröffentlichungstag der Anmeldung:
**20.02.80 Patentblatt 80/4**

(45) Bekanntmachung des Hinweises auf die Patenterteilung:
**15.07.81 Patentblatt 81/28**

(84) Benannte Vertragsstaaten:
**FR GB IT**

(56) Entgegenhaltungen:
**FR-A-2 070 742**
**FR-A-2 113 906**
**FR-A-2 303 382**
**US-A-3 590 345**

(73) Patentinhaber: **SIEMENS AKTIENGESELLSCHAFT Berlin und München, Postfach 22 02 61, D-8000 München 22 (DE)**

(72) Erfinder: **Johannsen, Rolf, Dipl.-Phys., Anechostrasse 32, D-8000 München 82 (DE)**

EP 0 008 106 B1

# Halbleitervorrichtung mit mehreren in einem Halbleiterkristall vereinigten und eine integrierte Schaltung bildenden Halbleiterelementen mit pn-Übergängen

Die Erfindung betrifft eine Halbleitervorrichtung mit mehreren in einem Halbleiterkristall vereinigten und eine integrierte Schaltung bildenden Halbleiterelementen mit pn-Übergängen, bei der mindestens eines dieser Halbleiterelemente in einem durch einen pn-Übergang von den übrigen Teilen des Halbleiterkristalls getrennten Bereich B des Halbleiterkristalls erzeugt ist, und bei der dieser pn-Übergang durch eine festgehaltene Gleichspannung in Sperrichtung vorgespannt ist.

Integrierte Halbleiterschaltungen dieser Art sind allgemein üblich und z.B. in «Industrie-Elektrik + Elektronik» 12. Jahrg. 1967, Nr. B 7/8, S. 125–128 beschrieben. Da man bei der Herstellung solcher integrierter Schaltungen in der Hauptsache Transistoren verwendet, bildet gewöhnlich der abgrenzende pn-Übergang die äussere Begrenzung des Kollektors oder des Emitters eines Vertikaltransistors oder der Basis eines Lateraltransistors vom npn- oder vom pnp-Typ, der ggf. mit weiteren Halbleiterelementen, insbesondere Transistoren, kombiniert ist.

Bei der Herstellung geht man von einem scheibenförmigen Halbleitereinkristall, insbesondere Siliciumeinkristall, des einen Leitfähigkeitstyps aus, auf dessen einer Oberflächenseite eine einkristalline Schicht desselben Halbleitermaterials aber vom entgegengesetzten Leitfähigkeitstyp epitaktisch niedergeschlagen wird. Durch maskierte Diffusion oder Implantation werden dann in der epitaktischen Schicht streifenförmige Isolationszonen vom Leitfähigkeitstyp des Substrats derart erzeugt, dass sie sich über ihre Gesamtlänge mit dem Substrat verbinden, so dass aus der epitaktischen Schicht voneinander getrennte inselförmige Bereiche B entstehen, welche den ursprünglichen Leitfähigkeitstyp der epitaktischen Schicht beibehalten haben und in eine Umgebung vom entgegengesetzten Leitfähigkeitstyp eingebettet sind. In den einzelnen Inseln werden dann in bekannter Weise Halbleiterelemente, insbesondere je ein Transistor, erzeugt und mit anderen in den inselförmigen Bereichen B erzeugten Halbleiterelementen durch Leiterbahnen usw. zu der gewünschten integrierten Schaltung verbunden.

Da die Anordnung mehrere Schaltungselemente in einem gemeinsamen Halbleiterkristall von endlichem Widerstand Massnahmen erfordert, um die Halbleiterelemente gegeneinander elektrisch zu isolieren und das soeben beschriebene Isolationsverfahren am wenigsten aufwendig ist, hat dieses in der Praxis eine erhebliche Bedeutung. Im allgemeinen wird die epitaktische Schicht durch ein Netz von rahmenförmigen Isolationszonen vom Leitfähigkeitstyp des Substrats in zueinander kongruente rechteckförmige inselförmige Bereiche B unterteilt, so dass sich zwischen je zwei dieser Inseln jeweils zwei gegeneinander geschaltete Dioden befinden. Unabhängig von der Polarität der Spannungsdifferenz zwischen den einzelnen Inseln B sind diese normalerweise immer durch eine gesperrte Diode voneinander isoliert. Es ist jedoch zweckmässig, alle Dioden stets gut gesperrt zu halten. Das wird erreicht, indem man das Substrat an das niedrigste in der integrierten Schaltung vorkommende Potential im Falle eines p-dotierten Substrats und im Falle eines n-dotierten Substrats an das höchste Potential legt. Das niedrigste und das höchste Potential ist im allgemeinen durch die beiden Pole der Speisequelle gegeben.

Für die weitere Betrachtung wird angenommen, dass das Substrat und die Isolationen p-dotiert und die die Elemente der integrierten Schaltung aufnehmenden Inseln n-dotiert sind. Für den umgekehrten Fall ergeben sich, wie leicht ersichtlich, analoge Verhältnisse.

Häufig bringt der Einsatz einer integrierten Schaltung in der Praxis aber auch Spannungen und damit Potentiale an die integrierte Schaltung, die negativer als das Substratpotential $V_s$ sind. Für diesen Fall kann man sog. Abfangdioden einsetzen, die in Gestalt von Zenerdioden solch hohe negative Spannungen abfangen, um die Entstehung von Strömen im Substrat zu unterbinden. Solche Ströme erzeugen nämlich auf ihrem Weg bis zum nächsten metallischen Substratanschluss Spannungsabfälle mit parasitären Auswirkungen, was sich z.B. in einer Umpolung vorher gesperrter pn-Übergänge, insbesondere auch von isolierenden pn-Übergängen, in der Entstehung von sog. Mehrschichtern oder sogar in der Zerstörung der integrierten Schaltung äussern kann.

Eine solche Zenerdiode, deren Kathode am Substratpotential $V_s$ und deren Anode an dem Signalpotential $V_{si}$ für die in der betreffenden Insel B realisierten Halbleiterelemente liegt, hat an der Kathode den Leitungstyp des Substrats S und an der Anode den Leitungstyp der Insel B, so dass im normalen Betrieb die der betreffenden Insel B zugeordnete Zenerdiode sich im gesperrten Zustand befindet. Lediglich beim Absinken des Signalpotentials unter das Substratpotential $V_s$ wird die Zenerdiode leitend und führt dann den sonst über das Substrat fliessenden Strom und bewahrt dadurch die übrige Schaltung von den oben genannten Auswirkungen.

Die Anwendung einer Schutzdiode ist jedoch wegen der Trägheit solcher Halbleiterelemente nicht immer zufriedenstellend. Vor allem wird aber die gewöhnlich innerhalb des inselförmigen Bereiches B erzeugte Zenerdiode, sobald diese leitend wird, zu einem parasitären pnp-Transistor mit dem Substrat als Kollektor.

Erfindungsgemäss wird deshalb vorgeschlagen, dass bei der eingangs definierten Halbleitervorrichtung die beiden den den Bereich B begrenzenden pn-Übergang in Sperrichtung liegenden Betriebspotentiale an die Basis bzw. an den Kollektor eines Transistors geschaltet sind, dessen Emitter durch das dem im Bereich B erzeugten Halbleiterelement zugeführte Signalpotential

beaufschlagt ist.

Bevorzugt ist dabei vorgesehen, dass das dem am begrenzenden pn-Übergang befindlichen Teil des Bereiches B angelegte Betriebspotential als Kollektorpotential $V_C$ und das dem jenseits des begrenzenden pn-Übergangs liegenden und an diesem angrenzenden Teil S des Halbleiterkristalls (Substrat) angelegte Betriebspotential $V_s$ als Basispotential für den Schutztransistor verwendet ist.

Mit solchen Massnahmen wird erreicht, dass beim Auftreten von Signalen, deren Spannung zu einer Umpolung und damit zum Auftreten einer Flussspannung zwischen dem Substrat S und dem Halbleiterbereich B führen würde, der entstehende Substratstrom um den Faktor B (B = Stromverstärkung des Schutztransistors) verringert wird. Bei der bevorzugten Ausgestaltung des Schutztransistors wird noch erreicht, dass der Emitter-Basis-pn-Übergang des Schutztransistors normalerweise in Sperrichtung liegt.

Im Interesse einer Rationalisierung der Herstellung einer solchen Halbleitervorrichtung ist man nicht nur daran interessiert, den Schutztransistor auf demselben Halbleiterchip wie die eigentliche integrierte Schaltung zu erzeugen, sondern man möchte auch zusätzliche Arbeitsschritte möglichst vermeiden. Man ist also bestrebt, den Schutztransistor bzw. die Schutztransistoren simultan mit dem im Halbleiterbereich B zu erzeugenden Halbleiterelement, insbesondere einem Transistor, herzustellen. Zu bemerken ist ausserdem, dass ggf. mehrere solche Schutztransistoren in einer integrierten Schaltung nötig sein können, wobei man allerdings bestrebt sein wird, einem Schutztransistor möglichst viele Halbleiterbereiche B zuzuordnen.

Ein weiterer Gesichtspunkt bei der Realisierung eines sog. «Layouts», d.h. der Konstruktion einer integrierten Schaltung, die im kostengünstigsten Herstellungsverfahren mit nur einer Metallisierungsebene eine kreuzungsfreie Verknüpfung der Halbleiterelemente, wie Transistoren, Widerstände usw. herstellen muss, ist, dass der Schutztransistor mit seinem p-Basisgebiet direkt mit dem p-Substratgebiet S in Verbindung stehen darf. Hierdurch kann die zum Basiskontakt des Schutztransistors führende metallische Leitbahn eingespart werden.

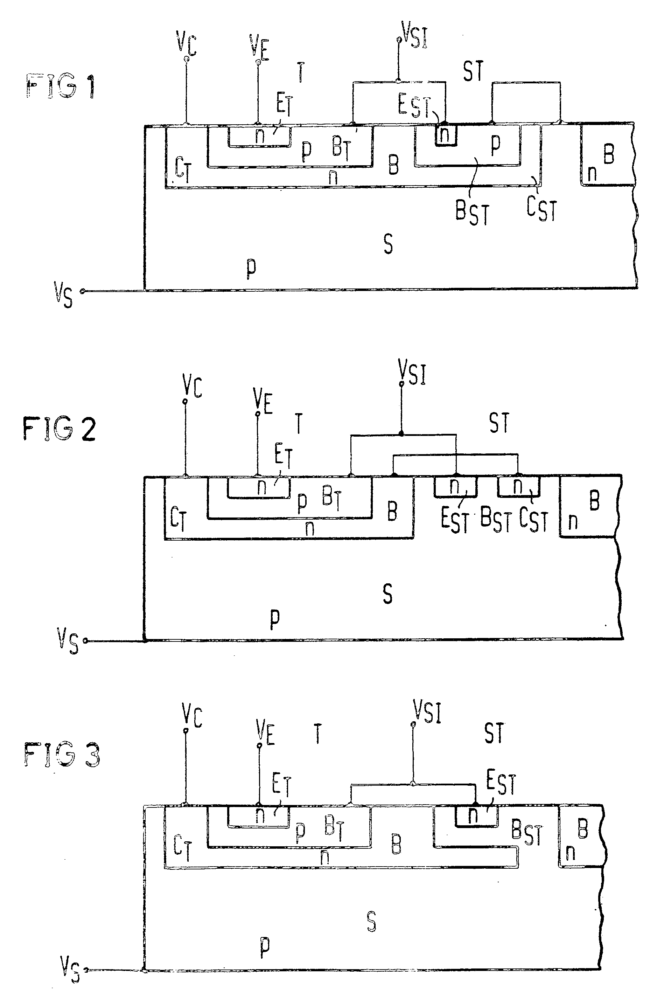

Die verschiedenen Möglichkeiten werden nun anhand der Fig. 1–3 vorgestellt.

In allen drei Fällen ist auf einem einkristallinen p-dotierten Siliciumplättchen eine n-dotierte einkristalline Siliciumschicht in bekannter Weise abgeschieden und durch lokalisierte Diffusion und/oder Implantation in einzelne n-leitende Inseln B unterteilt, die durch ein Netz von p-leitenden Isolationszonen, die über ihre ganze Ausdehnung mit dem p-leitenden Substrat S in Verbindung stehen, voneinander getrennt sind. In den drei Figuren sind die Isolationszonen, die sich ja in elektrischer Beziehung nicht anders als das Substrat S verhalten und mit diesem einen zusammenhängenden p-leitenden Halbleiterbereich bilden, nicht mit einem besonderen Bezugszeichen versehen worden.

Das eigentliche in der n-leitenden Insel, also dem Halbleiterbereich B, zu erzeugende Halbleiterelement ist im Falle der Fig. 1–3 ein npn-Transistor T, der als Vertikaltransistor ausgebildet ist. Er hat eine Emitterzone $E_T$, eine Basiszone $B_T$ und eine Kollektorzone $C_T$, die durch den unmittelbar an dem den Bereich B abgrenzenden pn-Übergang anliegenden Teil des Bereiches B gegeben ist. Im Betrieb liegt der Kollektor des Transistors T der integrierten Schaltung an einem Kollektorpotential $V_C$, der Emitter auf dem Potential $V_E$ und die Basis auf dem Signalpotential $V_{si}$. In allen Fällen wird man das Substratpotential $V_s$ als das negativste der insgesamt vorgesehenen Betriebsspannungspotentiale vorsehen, so dass im Normalfall der pn-Übergang zwischen der Kollektorzone $C_T$ und dem Substrat S immer in Sperrichtung liegt.

Nun ist bei der in Fig. 1 dargestellten Ausführungsform auch der Schutztransistor ST ein vertikaler npn-Transistor, so dass es keine Schwierigkeiten bereitet, beide Transistoren T und ST nebeneinander in dem Halbleiterbereich B in der aus Fig. 1 ersichtlichen Anordnung zu erzeugen, was in üblicher Weise geschieht. Dabei ist der Kollektor $C_{ST}$ des Schutztransistors ST und der Kollektor $C_T$ des einen Bestandteil der integrierten Halbleiterschaltung bildenden Transistors T in einer zusammenhängenden n-leitenden Zone vereinigt. Weitere Ausgestaltungen dieser Zone, z.B. durch n$^+$-dotierte buried-layer-Zonen, können ohne weiteres vorgesehen sein. Sie spielen aber im Rahmen dieser Erfindung keine besondere Rolle.

Die Kontaktierung des Schutztransistors ST wird so getroffen, dass sein Emitter $E_{ST}$ an dem den Transistor T steuernden Signalpotential $V_{si}$ liegt. Dies liegt im Beispielsfalle und bevorzugt an der Basis des Transistors T; es könnte aber auch analog zum Schutztransistor ST am Emitter $E_T$ des Transistors T liegen. Am Kollektor $C_{ST}$ des Schutztransistors ST liegt das Potential des Kollektors des Transistors T, was durch die in Fig. 1 dargestellte Ausgestaltung bereits ohne einen zusätzlichen Anschluss am Kollektor $C_{ST}$ der Fall ist. Die Basis des Schutztransistors $B_{ST}$ ist an das Substratpotential $V_s$ gelegt.

Bei der in Fig. 2 dargestellten Ausgestaltung ist der Schutztransistor ST als npn-Lateraltransistor innerhalb einer an den den npn-Transistor T enthaltenden Halbleiterbereich B angrenzenden p-leitenden Isolationszone, also in dem mit dem Substrat gemeinsamen p-dotierten Halbleiterbereich S erzeugt. Dies geschieht zweckmässig gleichzeitig mit der Herstellung des Emitters $E_T$ des Transistors T, indem die hierzu zu verwendende Dotierungsmaske auch an der Oberfläche des p-leitenden Bereiches ausserhalb des den Transistor T aufnehmenden n-leitenden Bereich B am Ort des Transistors ST mit zwei nebeneinander angeordneten Dotierungsfenstern versehen wird. Dann entsteht gleichzeitig mit der n-leitenden Emitterzone $E_T$ des Transistors T eine n-leitende Emitterzone $E_{ST}$ sowie daneben eine n-leitende Kollektorzone $C_{ST}$ für den Schutztransistor ST derart, dass beide Zonen völlig im Bereich S liegen.

In dem in Fig. 2 dargestellten Fall wird wiederum der Emitter des Schutztransistors ST an das der Basiszone $B_T$ des Transistors T zugeführte Signalpotential $V_{si}$ gelegt, während der Kollektor $C_{ST}$ des Schutztransistors ST am Potential $V_C$ des Kollektors $C_T$ des Transistors T liegt, wozu im Gegensatz zu einer Ausgestaltung gemäss Fig. 1 eine besondere auf einer die Halbleiteroberfläche abdeckenden Isolierschicht, insbesondere $SiO_2$-Schicht, verlegte Leiterbahn erforderlich ist. Da in dem in Fig. 2 dargestellten Ausführungsbeispiel die Basis des Schutztransistors ST mit dem Substrat S eine zusammenhängende p-leitende Zone S bildet, ist bereits hierdurch eine Beaufschlagung der Basis $B_{ST}$ des Schutztransistors ST durch das am Substrat anliegende Substratpotential $V_s$ gegeben.

Die in Fig. 3 dargestellte Ausgestaltung stellt einen Zwischenfall zu den in Fig. 1 und Fig. 2 dargestellten Anordnungen dar, wobei jedoch der Schutztransistor ST wie im Beispiel gemäss Fig. 1 als Vertikaltransistor ausgebildet ist. Durch entsprechende Auslegung der für die Herstellung der Basiszonen $B_T$ und $B_{ST}$ der Transistoren T und ST verwendeten Dotierungsmaske ist dafür gesorgt worden, dass die Basiszone des Schutztransistors ST mit der das Substrat enthaltenden p-leitenden Zone S eine zusammenhängende p-dotierte Zone bildet, so dass im Falle einer Ausgestaltung gemäss Fig. 3 weder ein besonderer Anschluss für den Kollektor $C_{ST}$ noch ein besonderer Anschluss für die Basis $B_{ST}$ des Schutztransistors $T_{ST}$ erforderlich ist.

Auf eine Darstellung der isolierenden Schutzschichten an der Halbleiteroberfläche ist in den Fig. Abstand genommen. Auch die Anschlusselektroden und leitenden Verbindungen sind nur schematisch dargestellt.

**Patentansprüche**

1. Halbleitervorrichtung mit mehreren in einem Halbleiterkristall (S) vereinigten und eine integrierte Schaltung bildenden Halbleiterelementen (T) mit pn-Übergängen, bei der mindestens eines dieser Halbleiterelemente in einem durch einen pn-Übergang von den übrigen Teilen des Halbleiterkristalls getrennten Bereich (B) des Halbleiterkristalls erzeugt ist, und bei der dieser pn-Übergang durch eine festgehaltene Gleichspannung in Sperrichtung vorgespannt ist, dadurch gekennzeichnet, dass die beiden den den Bereich (B) begrenzenden pn-Übergang in Sperrichtung liegenden Betriebspotentiale an die Basis bzw. an den Kollektor eines Schutztransistors (ST) geschaltet sind, dessen Emitter ($E_{ST}$) durch das dem im Bereich B erzeugten Halbleiterelement (T) zugeführte Signalpotential($V_{si}$) beaufschlagt ist.

2. Halbleitervorrichtung nach Anspruch 1, dadurch gekennzeichnet, dass das den am begrenzenden pn-Übergang befindlichen Teil ($C_T$) des Bereiches (B) beaufschlagende Betriebspotential als Kollektorpotential ($V_C$) und das den jenseits des begrenzenden pn-Übergangs liegenden und an diesem angrenzenden Teil (S) des Halbleiterkristalls beaufschlagende Betriebspotential ($V_s$) als Basispotential für den Schutztransistor (ST) verwendet ist.

3. Halbleitervorrichtung nach Anspruch 1 oder 2, dadurch gekennzeichnet, dass der Schutztransistor (ST) als Vertikaltransistor ausgebildet ist, dessen Kollektor ($C_{ST}$) durch den an dem begrenzenden pn-Übergang liegenden Teil des Bereiches (B) gegeben ist.

4. Halbleitervorrichtung nach den Ansprüchen 1 bis 3, dadurch gekennzeichnet, dass der Schutztransistor (ST) innerhalb des Bereiches (B) erzeugt ist (Fig. 1).

5. Vorrichtung nach Anspruch 3, dadurch gekennzeichnet, dass die Basiszone ($B_{ST}$) des Schutztransistors (ST) zusammen mit dem ausserhalb des Bereiches (B) liegenden und an dem den Bereich (B) begrenzenden pn-Übergang liegenden Teil des Halbleiterkristalls eine zusammenhängende Zone vom einen Leitfähigkeitstyp bildet (Fig. 3).

6. Halbleitervorrichtung nach Anspruch 1 oder 2, dadurch gekennzeichnet, dass der Schutztransistor (ST) ein Lateraltransistor ist (Fig. 2).

7. Halbleitervorrichtung nach Anspruch 6, dadurch gekennzeichnet, dass der Schutztransistor (ST) ausserhalb des Bereichs B in einem unmittelbar an dem den Bereich B begrenzenden pn-Übergang anliegenden Teil (S) des Halbleiterkristalls erzeugt ist (Fig. 2).

8. Halbleitervorrichtung nach den Ansprüchen 1 bis 7, dadurch gekennzeichnet, dass der Schutztransistor (ST) simultan mit dem der eigentlichen integrierten Schaltung zugehörigen Halbleiterelement des Bereiches (B), insbesondere einem Transistor (T), erzeugt ist.

**Claims**

1. A semiconductor device comprising a plurality of semiconductor elements (T) having pn-junctions, which are combined in a semiconductor crystal to constitute an integrated circuit, wherein at least one of said semiconductor elements is produced in a zone (B) of the semiconductor crystal which is separated from the remaining parts of the semiconductor crystal by a pn-junction, and wherein said pn-junction is biased in the reverse direction by a clamped direct voltage, characterised in that the two operating potentials which bias the pn-junction, forming the boundary of the zone B, in the reverse direction, are connected to the base and to the collector respectively of a protective transistor (ST), the emitter ($E_{ST}$) of which protective transistor is supplied with the signal potential ($V_{si}$) fed to the semiconductor element (T) formed in the zone B.

2. A semiconductor device as claimed in Claim 1, characterised in that the operating potential supplied to the part ($C_T$) of the zone B which adjoins the boundary pn-junction serves as the col-

7  0 008 106  8

lector potential ($V_C$) of the protective transistor (ST), and the operating potential ($V_s$) supplied to the part (S) of the semiconductor crystal which lies on the other side of and adjoining the boundary pn-junction serves as the base potential for the protective transistor (ST).

3. A semiconductor device as claimed in Claim 1 or 2, characterised in that the protective transistor (ST) is formed as a vertical transistor, the collector ($C_{ST}$) of which is given by the part of the zone (B) which lies adjacent the boundary pn-junction.

4. A semiconductor device as claimed in Claims 1 to 3, characterised in that the protective transistor (ST) is formed within the zone (B) (Fig. 1).

5. A device as claimed in Claim 3, characterised in that the base zone ($B_{ST}$) of the protective transistor (ST) and the part of the semiconductor crystal which lies outside the zone (B) and adjacent to the pn-junction forming the boundary of the zone B, together form a continuous zone of one conductivity type (Fig. 3).

6. A semiconductor device as claimed in Claim 1 or 2, characterised in that the protective transistor (ST) is a lateral transistor (Fig. 2).

7. A semiconductor device as claimed in Claim 6, characterised in that the protective transistor (ST) is produced outside the zone B in a part (S) of the semiconductor crystal which directly adjoins the pn-junction bounding the zone B (Fig. 2).

8. A semiconductor device as claimed in Claims 1 to 7, characterised in that the protective transistor (ST) is produced simultaneously with the semiconductor element of the zone B, in particular a transistor (T), which forms part of the actual integrated circuit.

## Revendications

1. Dispositif à semiconducteurs comportant plusieurs éléments semiconducteurs (T) à jonctions pn réunis dans un cristal semiconducteur et formant un circuit intégré, dispositif dans lequel au moins un de ces éléments semiconducteurs est réalisé dans une région (B) du cristal semiconducteur qui est séparée par une jonction pn des autres parties du cristal semiconducteur et dans lequel cette jonction pn est polarisée en direction inverse par une tension continue fixe caractérisé par le fait que les deux potentiels de fonctionnement qui amènent la jonction pn limitant la région (B) dans son état de blocage, sont appliqués respectivement à la base et au collecteur d'un transistor de protection (ST) dont l'émetteur ($E_{ST}$) est chargé par le potentiel du signal ($V_{Si}$) appliqué à l'élément semiconducteur (T) produit dans la région (B).

2. Dispositif à semiconducteurs selon la revendication 1, caractérisé par le fait que le potentiel de fonctionnement chargeant la partie ($C_T$) de la région B qui se trouve à la jonction pn formant limite, est utilisé comme potentiel de collecteur ($V_C$), alors que le potentiel de fonctionnement ($V_s$) chargeant la partie (S) du cristal semiconducteur située au-delà de la jonction pn formant limite et jouxtant ce dernier, est utilisé comme potentiel de base pour le potentiel de protection.

3. Dispositif à semiconducteurs selon la revendication 1 ou 2, caractérisé par le fait que le transistor de protection (ST) est réalisé sous la forme d'un transistor vertical dont le collecteur ($C_{ST}$) est donné par la partie de la région (B) se situant près de la jonction pn formant limite.

4. Dispositif à semiconducteurs selon les revendications 1 à 3, caractérisé par le fait que le transistor de protection (ST) est produit à l'intérieur de la région (B) (fig. 1).

5. Dispositif à semiconducteurs selon la revendication 3, caractérisé par le fait que la zone de base ($B_{ST}$) du transistor de protection (ST) forme avec la partie du cristal semiconducteur située près de la jonction pn limitant la région B, une zone d'un seul tenant d'un type de conductibilité.

6. Dispositif à semiconducteurs selon la revendication 1 ou 2, caractérisé par le fait que le transistor de protection (ST) est un transistor latéral (fig. 2).

7. Dispositif à semiconducteurs selon la revendication 6, caractérisé par le fait que le transistor de protection (ST) est produit en dehors de la région B, dans une partie (S) du cristal semiconducteur jouxtant la jonction pn qui limite la région B (fig. 2).

8. Dispositif à semiconducteurs selon les revendications 1 à 7, caractérisé par le fait que le transistor de protection (ST) est produit en même temps que l'élément semiconducteur de la région B appartenant au circuit intégré proprement dit, plus particulièrement en même temps qu'un transistor (T).

FIG 1

$V_C$   $V_E$   T   $V_{SI}$   ST

$E_T$   $E_{ST}$

n   p   $B_T$   B   n   p   $B$

$C_T$   n   n

$B_{ST}$   $C_{ST}$

S

p

$V_S$

FIG 2

$V_C$   $V_E$   T   $V_{SI}$   ST

$E_T$

n   p   $B_T$   B   n   n   $B$

$C_T$   n   $E_{ST}$   $B_{ST}$ $C_{ST}$   n

S

p

$V_S$

FIG 3

$V_C$   $V_E$   T   $V_{SI}$   ST

$E_T$   $E_{ST}$

n   p   $B_T$   B   n   $B$

$C_T$   n   $B_{ST}$   n

S

p

$V_S$